(19) Europäisches Patentamt
European Patent Office
Office européen des brevets

(11) EP 3 848 977 B1

(12) **EUROPEAN PATENT SPECIFICATION**

(45) Date of publication and mention of the grant of the patent:
**26.06.2024 Bulletin 2024/26**

(21) Application number: **19858491.4**

(22) Date of filing: **09.08.2019**

(51) International Patent Classification (IPC):
***H10K 10/46*** *(2023.01)*

(52) Cooperative Patent Classification (CPC):
**H10K 10/472; H10K 10/474;** H10K 71/18

(86) International application number:
**PCT/JP2019/031628**

(87) International publication number:
**WO 2020/049956 (12.03.2020 Gazette 2020/11)**

(54) **ORGANIC THIN FILM TRANSISTOR AND METHOD OF MANUFACTURING ORGANIC THIN FILM TRANSISTOR**

ORGANISCHER DÜNNSCHICHTTRANSISTOR UND VERFAHREN ZUR HERSTELLUNG EINES ORGANISCHEN DÜNNSCHICHTTRANSISTORS

TRANSISTOR EN COUCHES MINCES ORGANIQUES ET PROCÉDÉ DE FABRICATION DE TRANSISTOR EN COUCHES MINCES ORGANIQUES

(84) Designated Contracting States:
**AL AT BE BG CH CY CZ DE DK EE ES FI FR GB GR HR HU IE IS IT LI LT LU LV MC MK MT NL NO PL PT RO RS SE SI SK SM TR**

(30) Priority: **03.09.2018 JP 2018164317**

(43) Date of publication of application:
**14.07.2021 Bulletin 2021/28**

(73) Proprietor: **FUJIFILM Corporation**
**Tokyo 106-8620 (JP)**

(72) Inventors:
- **IWASE, Eijiro**
  **Minamiashigara-shi, Kanagawa 250-0193 (JP)**
- **TONOHARA, Koji**
  **Minamiashigara-shi, Kanagawa 250-0193 (JP)**
- **SUGIURA, Hiroki**
  **Minamiashigara-shi, Kanagawa 250-0193 (JP)**

(74) Representative: **Klunker IP**
**Patentanwälte PartG mbB**
**Destouchesstraße 68**
**80796 München (DE)**

(56) References cited:
**WO-A1-2013/143280**
**JP-A- 2005 311 365**
**JP-A- 2006 013 480**
**JP-A- 2006 093 667**
**JP-A- 2007 027 525**
**JP-A- 2013 084 725**
**JP-A- 2017 171 736**

- **DIALLO K ET AL: "Flexible pentacene ion sensitive field effect transistor with a hydrogenated silicon nitride surface treated Parylene top gate insulator", APPLIED PHYSICS LETTERS, A I P PUBLISHING LLC, US, vol. 93, no. 18, 7 November 2008 (2008-11-07), pages 183305-183305, XP012112229, ISSN: 0003-6951, DOI: 10.1063/1.3013578**
- **Li Flora M.: "Organic Thin Film Transistor Integration", Organic Thin Film Transistor Integration, 23 May 2008 (2008-05-23), pages 1-286, XP055843345, Waterloo, CA Retrieved from the Internet: URL:https://uwspace.uwaterloo.ca/handle/10012/3745**

Note: Within nine months of the publication of the mention of the grant of the European patent in the European Patent Bulletin, any person may give notice to the European Patent Office of opposition to that patent, in accordance with the Implementing Regulations. Notice of opposition shall not be deemed to have been filed until the opposition fee has been paid. (Art. 99(1) European Patent Convention).

EP 3 848 977 B1

## Description

### BACKGROUND OF THE INVENTION

1. Field of the Invention

The present invention relates to an organic thin film transistor and a method of manufacturing the organic thin film transistor.

2. Description of the Related Art

Unlike an inorganic semiconductor in the related art, an organic semiconductor is formed of organic molecules that are soluble in various solvents. Therefore, the organic semiconductor can be formed by application, a printing technique, or the like. Therefore, the organic semiconductor can be used for various devices that are manufactured using roll-to-roll (hereinafter, also referred to as "R-to-R"). Various organic thin film transistors formed of the organic semiconductor are disclosed.

As a general configuration of the organic thin film transistor, a gate electrode is formed on a substrate, an insulating film covers the gate electrode, an organic semiconductor layer is formed on the insulating film, and a source electrode and a drain electrode are formed on the organic semiconductor layer.

Many techniques of imparting flexibility to an organic thin film transistor by using an organic semiconductor as a semiconductor are disclosed. However, in order to impart flexibility to the organic thin film transistor, it is necessary that another material forming the organic thin film transistor exhibits not only bendability but also performance.

In particular, the insulating film that separates the organic semiconductor layer and the gate electrode from each other has a problem. The reason for this is that, in a case where cracking occurs in the insulating film, a current is short-circuited, and thus a desired response speed cannot be obtained.

It is known that, as the insulating film, an inorganic film such as a $SiO_2$ film or a SiN film is formed of a vapor deposition film.

For example, JP2015-177099A describes a transistor including: a gate electrode; an organic semiconductor film that faces the gate electrode; a protective film that covers a part of the organic semiconductor film; and a pair of source-drain electrodes that are electrically connected to the organic semiconductor film and are spaced from each other. JP2015-177099A describes that an inorganic insulating material such as silicon oxide ($SiO_x$) or silicon nitride (SiNx) is used as an gate insulating film for insulating the gate electrode and the organic semiconductor film.

In addition, JP2015-177099A also discloses that the insulating film is formed using an insulating organic material.

For example, JP2015-177099A describes that an organic insulating material such as polyvinyl phenol (PVP) or polyimide is used as the insulating film.

However, in a case where an organic film is used as the insulating film, the density as the material is low. Therefore, there is a problem in that short-circuiting occurs due to a pinhole or a solvent or the like remains during the formation such that the organic semiconductor is affected. In addition, since there is a problem in that it is difficult to apply the organic material uniformly and thinly, there is a problem in practical application.

WO 2013/143280 A1 discloses an organic thin film transistor comprising: a gate electrode; a gate insulating layer that is formed to cover the gate electrode; an organic semiconductor layer that is formed on the gate insulating layer; and a source electrode and drain electrode that are formed on the organic semiconductor layer in Fig. 7. The gate insulating layer is made of SiNx. The SiNx layer can be formed by PECVD (Plasma Enhanced Chemical Vapor Deposition) from a mixed gas of $SiH_4$, $NH_3$ and $N_2$.

"Flexible pentacene ion sensitive field effect transistor with a hydrogenated silicon nitride surface treated Parylene top gate insulator" by Diallo K et al, APPLIED PHYSICS LETTERS, A I P PUBLISHING LLC, US, vol. 93, no. 18, page 183305 (2008), discloses a structure comprising a substrate, source/drain contacts, pentacene layer, parylene layer, SiN:H layer, and Al gate in Fig. 1.

"Organic Thin Film Transistor Integration" by Li Flora M., published on May 23, 2008 discloses a bottom-gate top-contact organic thin film transistor comprising a plastic substrate, a bottom-gate, a gate dielectric (SiNx, SiOx), a polymer semiconductor (PQT-12) and source/drain contacts in Fig. 4.28 of Sec. 4.3.5 in page 152. According to Sec. 4.2.1 in pages 117 to 123, SiNx includes N-H and Si-H bonds.

### SUMMARY OF THE INVENTION

In a case where an inorganic film is used as the insulating film and the thickness of the inorganic film is small, a pinhole is formed such that the gate electrode and the organic semiconductor layer are short-circuited. Therefore, in order to suppress the formation of the pinhole in the inorganic film, for example, it is necessary that the thickness of the

inorganic film is adjusted to about 1 μm or more. However, in a case where the inorganic film is thick, there is a problem in that bendability deteriorates.

An object of the present invention is to solve the above-described problems and to provide an organic thin film transistor that has high bendability and can suppress a decrease in carrier mobility caused by a pinhole of an insulating film or leveling properties and a method of manufacturing the organic thin film transistor.

The present invention is defined by the appended claims.

According to the present invention, it is possible to provide an organic thin film transistor that has high bendability and can suppress a decrease in carrier mobility caused by a pinhole of an insulating film or leveling properties and a method of manufacturing the organic thin film transistor.

## BRIEF DESCRIPTION OF THE DRAWINGS

Fig. 1 is a cross-sectional view conceptually showing an example of an organic thin film transistor according to the present invention.
Fig. 2 is a cross-sectional view conceptually showing another example of the organic thin film transistor according to the present invention.
Fig. 3 is a cross-sectional view conceptually showing still another example of the organic thin film transistor according to the present invention.
Fig. 4 is a cross-sectional view conceptually showing still another example of the organic thin film transistor according to the present invention.
Fig. 5 is a diagram showing one example of a method of manufacturing the organic thin film transistor according to the present invention.
Fig. 6 is a diagram showing the example of the method of manufacturing the organic thin film transistor according to the present invention.
Fig. 7 is a diagram showing the example of the method of manufacturing the organic thin film transistor according to the present invention.
Fig. 8 is a diagram showing the example of the method of manufacturing the organic thin film transistor according to the present invention.
Fig. 9 is a diagram showing the example of the method of manufacturing the organic thin film transistor according to the present invention.
Fig. 10 is a diagram showing the example of the method of manufacturing the organic thin film transistor according to the present invention.

## DESCRIPTION OF THE PREFERRED EMBODIMENTS

Hereinafter, an embodiment of an organic thin film transistor according to the present invention and a method of manufacturing the organic thin film transistor will be described based on the drawings. In the drawings of the present specification, dimensions of respective portions are appropriately changed in order to easily recognize the respective portions.

In the present specification, numerical ranges represented by "to" include numerical values before and after "to" as lower limit values and upper limit values.

In the following description, "thickness" refers to a length in a direction (hereinafter, thickness direction) in which a support, a gate electrode, an insulating film, an organic semiconductor layer, and the like are arranged (laminated).

[Organic Thin Film Transistor]

An organic thin film transistor according to the embodiment of the present invention comprises:

a gate electrode;
an insulating film that is formed to cover the gate electrode;
an organic semiconductor layer that is formed on the insulating film, and
a source electrode and a drain electrode that are formed on the organic semiconductor layer,
in which the insulating film includes an inorganic film consisting of SiNH.

Fig. 1 conceptually shows one example of the organic thin film transistor according to the embodiment of the present invention.

Fig. 1 is a cross-sectional view schematically showing a cross-section of the organic thin film transistor according to the embodiment of the present invention in a direction perpendicular to a main surface. The main surface is the maximum surface of a sheet-shaped material (a film or a plate-shaped material).

An organic thin film transistor 10a shown in Fig. 1 includes a support 12 and a transistor element 18 that is formed on the support 12.

The transistor element 18 includes: a gate electrode 20 that is formed on a surface of the support 12; an inorganic film (insulating film) 22 that is formed to cover the gate electrode 20; an organic semiconductor layer 24 that is formed on the inorganic film 22; and a source electrode 26 and a drain electrode 28 that are formed on the organic semiconductor layer 24 to be spaced from each other. That is, the transistor element 18 is a so-called bottom gate-top contact type transistor element.

In the following description, for convenience of description, the support 12 side will be referred to as "lower side", and the side of the source electrode 26 and the drain electrode 28 side will be referred to as "upper side".

Here, in the present invention, the insulating film includes an inorganic film consisting of hydrogenated silicon nitride (SiNH). In an example shown in Fig. 1, the inorganic film 22 consisting of SiNH is the insulating film.

The inorganic film (hereinafter, also referred to as "SiNH film") 22 consisting of SiNH has higher flexibility than an inorganic film such as a silicon oxide (SiO) film or a silicon nitride (SiN) film that is used as an insulating film in an organic thin film transistor in the related art. In addition, the SiNH film has excellent flexibility and is not likely to crack. Therefore, deterioration in insulating properties caused by cracking or the like is not likely to occur. Thus, in the organic thin film transistor according to the embodiment of the present invention, by using the inorganic film 22 consisting of SiNH as the insulating film, the insulating film can be made to have excellent insulating properties and excellent flexibility. As a result, the bendability of the organic thin film transistor can increase, and a decrease in carrier mobility caused by a pinhole of an insulating film or leveling properties can be suppressed.

Here, a ratio SiN:H of the number of SiN atoms to the number of H atoms in the SiNH film 22 is 1:0.7 to 2, preferably 1:0.8 to 1.8, and more preferably 1:0.9 to 1.5.

In a case where the ratio of H in the SiNH film 22 is high, the denseness of the film decreases, and thus bendability is improved. On the other hand, in a case where the ratio of H is excessively high, the denseness of the film is excessively low, and thus insulating properties may decrease. On the other hand, by adjusting the ratio SiN:H of the number of SiN atoms to the number of H atoms to the above-described range, bendability and insulating properties can be improved simultaneously.

The ratio SiN:H of the number of SiN atoms to the number of H atoms can be measured using Rutherford backscattering spectrometry/hydrogen forward scattering spectrometry (RBS/HFS).

Specifically, using RBS/HFS, the amount (number) of atoms of each of silicon, hydrogen, and nitrogen in the entire region in the thickness direction of the SiNH film 22 may be detected to calculate the ratio between the numbers of the atoms.

Alternatively, using X-ray photoelectron spectroscopy (XPS), the number of atoms of each of Si, N, and H on the surface of the SiNH film 22 may be measured to calculate the ratio between the number of SiN atoms and the number of H atoms.

In addition, from the viewpoint of bendability, it is preferable that the SiNH film 22 is as thin as possible. On the other hand, from the viewpoint of insulating properties, it is necessary that the SiNH film 22 is thick to some extent. From the above-described viewpoints, the thickness of the SiNH film 22 is preferably 1 nm to 100 nm, more preferably 5 nm to 80 nm, and still more preferably 10 nm to 50 nm.

Here, in the example shown in Fig. 1, the SiNH film 22 is directly laminated on the gate electrode 20. However, the present invention is not limited to this configuration, and another layer may be provided between the gate electrode 20 and the SiNH film 22.

For example, an organic thin film transistor 10b shown in Fig. 2 includes: the gate electrode 20 that is formed on a surface of the support 12; an organic layer 21 that is formed to cover the gate electrode 20; the SiNH film 22 that is formed on the organic layer 21; the organic semiconductor layer 24 that is formed on the SiNH film 22; and the source electrode 26 and the drain electrode 28 that are formed on the organic semiconductor layer 24 to be spaced from each other.

The organic layer 21 functions as an underlayer of the SiNH film 22. Although described below, it is preferable that the SiNH film 22 is formed by plasma chemical vapor deposition (CVD). In a case where the SiNH film 22 is formed by plasma CVD, it is difficult to directly form the SiNH film 22 on the gate electrode 20 as a conductor.

On the other hand, by providing the organic layer 21 on the gate electrode 20, the SiNH film 22 can be formed by plasma CVD. In addition, the organic layer 21 embeds unevenness on the formation surface of the SiNH film 22 and foreign matter attached thereto. As a result, by appropriately adjusting the formation surface of the SiNH film 22, the SiNH film 22 having no pinhole or the like can be appropriately formed at a uniform thickness.

In addition, although described below, the SiNH film 22 can be formed by being laminated on the gate electrode 20 by transfer. In this case, a transfer type laminated film (refer to Fig. 7) from which a substrate is peelable is prepared,

the substrate is peeled off from the transfer type laminated film, and the transfer layer including the SiNH film 22 is transferred to the gate electrode 20. In the transfer type laminated film, in order to allow the transfer layer to be peelable from the substrate, the SiNH film 22 is formed on the organic layer 21 formed on the substrate. By transferring the transfer layer such that the organic layer 21 side faces the gate electrode 20, the organic thin film transistor having the configuration shown in Fig. 2 can be obtained.

By forming the SiNH film 22 by transfer, the SiNH film 22 can be formed using a desired method such as plasma CVD under desired conditions irrespective of the configurations of the support 12 and the gate electrode 20.

In addition, as in an organic thin film transistor 10c shown in Fig. 3, the organic thin film transistor according to the embodiment of the present invention may be configured to include: the gate electrode 20 that is formed on a surface of the support 12; an adhesive layer 30 that is formed to cover the gate electrode 20; the SiNH film 22 that is formed on the adhesive layer 30; the organic layer 21 that is formed on the SiNH film 22; the organic semiconductor layer 24 that is formed on the organic layer 21; and the source electrode 26 and the drain electrode 28 that are formed on the organic semiconductor layer 24 to be spaced from each other.

In a case where the SiNH film 22 is laminated on the gate electrode 20 by transfer, the SiNH film 22 can also be laminated on the gate electrode 20 by bonding the SiNH film 22 side of the transfer type laminated film through the adhesive layer 30 and subsequently peeling the substrate of the transfer type laminated film from the transfer layer. In this case, as shown in Fig. 3, the SiNH film 22 as the insulating film is interposed between the adhesive layer 30 and the organic layer 21.

The organic layer 21 is not particularly limited as long as it functions as an underlayer of the SiNH film 22 and can appropriately adjust the formation surface of the SiNH film 22 by embedding unevenness or the like thereof. The organic layer 21 does not necessarily have insulating properties.

Likewise, the adhesive layer 30 is not particularly limited as long as the transfer layer including the SiNH film 22 can be bonded to the gate electrode 20. The adhesive layer 30 does not necessarily have insulating properties.

In addition, in a case where the organic layer 21 as the underlayer of the SiNH film 22 is provided, two or more combinations of the SiNH films 22 and the organic layers 21 may be provided. That is, for example, two or more organic layers 21, two or more organic layers and two or more SiNH films 22, for example, the organic layer 21, the SiNH film 22, the organic layer 21 and the SiNH film 22 may be provided on the gate electrode 20.

In addition, in the example shown in Fig. 1, the insulating film is configured to include the inorganic film 22 consisting of SiNH. However, the present invention is not limited to this configuration, and the insulating film may include another layer.

For example, an organic thin film transistor 10d shown in Fig. 4 includes the inorganic film 22 consisting of SiNH and a second inorganic film 23 as the insulating film. The organic thin film transistor 10d has the same configuration as that of the organic thin film transistor 10a shown in Fig. 1, except that it includes the second inorganic film 23.

As the second inorganic film 23, a well-known inorganic film such as a silicon oxide (SiO) film or a silicon nitride (SiN) film can be used. By providing the second inorganic film 23, high insulating properties can be obtained. In this case, since the SiNH film 22 is provided, even in a case where the second inorganic film 23 is thin, insulating properties can be secured, and deterioration in bendability can also be prevented.

In addition, it is preferable that a $SiO_2$ film is provided as the second inorganic film 23 on the organic semiconductor layer 24 side (hereinafter, also referred to as "surface layer") of the SiNH film 22. By providing the $SiO_2$ film on the surface layer of the SiNH film 22, a well-known surface treatment in the related art that is performed on a surface where an organic semiconductor such as a self-assemble monolayer (SAM) is formed can be performed. As a result, an organic semiconductor layer having high crystallinity can be easily formed on the surface of the insulating film, and the performance of the organic thin film transistor can be improved.

In a case where a silicon compound film such as a $SiO_2$ film or a SiN film is formed as the second inorganic film 23, the SiNH film 22 and the second inorganic film 23 may be formed as different layers to have a clear interface therebetween, or may be formed as a single layer such that the proportion of $SiO_2$ is higher in the surface layer of the SiNH film 22.

From the viewpoint of sufficiently obtaining the effect of the surface treatment, the thickness of the $SiO_2$ film is preferably 0.1 nm to 5 nm, more preferably 0.2 nm to 3 nm, and still more preferably 0.1 nm to 1 nm.

Hereinafter, the portion forming the organic thin film transistor will be described in detail.

<Support>

As the support 12, a well-known sheet-shaped material (a film or a plate-shaped material) that is used as a support in various organic thin film transistors can be used.

A material of the support 12 is not particularly limited, and various materials can be used as long as they can form the transistor element 18. Examples of the material of the support 12 include a plastic material, a silicon material, a glass material, quartz, and a ceramic material. In particular, from the viewpoints of applicability to each device and

costs, a glass material or a plastic material is preferable.

Examples of the plastic material include a polyester film such as polyethylene naphthalate (PEN) or polyethylene terephthalate (PET), a cycloolefin polymer film, a polycarbonate film, a triacetyl cellulose (TAC) film, and a polyimide film. In addition, the plastic film bonded to glass can also be used.

The thickness of the substrate is not particularly limited. The thickness of the substrate is, for example, preferably 10 mm or less, more preferably 2 mm or less, and still more preferably 1.5 mm or less. On the other hand, the thickness of the substrate is preferably 0.01 mm or more and more preferably 0.05 mm or more.

<Gate Electrode>

As the gate electrode 20, a well-known electrode in the related art that is used as a gate electrode for an organic thin film transistor can be used.

A conductive material (also referred to as "electrode material") which forms the gate electrode is not particularly limited. Examples of the conductive material include: a metal such as platinum, gold, silver, aluminum, chromium, nickel, copper, molybdenum, titanium, magnesium, calcium, barium, sodium, palladium, iron, or manganese; a conductive metal oxide such as $InO_2$, $SnO_2$, an indium-tin oxide (ITO), a fluorine-doped tin oxide (FTO), an aluminum-doped zinc oxide (AZO), or a gallium-doped zinc oxide (GZO); a conductive polymer such as polyaniline, polypyrrole, polythiophene, polyacetylene, or poly(3,4-ethylenedioxythiophene)/polystyrene sulfonate (PEDOT/PSS); an acid such as hydrochloric acid, sulfuric acid, or sulfonic acid; a Lewis acid such as $PF_6$, $AsF_5$, or $FeCl_3$: a halogen atom such as iodine; the above-described conductive polymer to which a dopant of a metal atom such as sodium or potassium is added; and a conductive composite material in which carbon black, graphite powder, metal particles, or the like are dispersed. Among these materials, one kind may be used alone, or any combination of two or more kinds may be used at any ratio.

In addition, the gate electrode may be a single layer consisting of the above-described conductive material or may be a laminate in which two or more layers are laminated.

A method of forming the gate electrode is not particularly limited. Examples of the method include a physical vapor deposition (PVD) method such as a vacuum deposition method, a chemical vapor deposition (CVD) method, a sputtering method, a printing method (application method), a transfer method, a sol-gel method, and a method of optionally patterning a film formed using a plating method or the like in a desired shape.

In the application method, a solution, a paste, or a dispersion liquid of the above-described material is prepared and applied, and a film can be formed by drying, firing, and photocuring or aging, or an electrode can be directly formed.

In addition, ink jet printing, screen printing, (reverse) offset printing, relief printing, intaglio printing, planographic printing, thermal transfer printing, a microcontact printing method, or the like is preferable from the viewpoints of obtaining a desired pattern, simplifying the steps, reducing the costs, and increasing the speed.

A spin coating method, a die coating method, a microgravure coating method, or a dip coating method is adopted, a pattern can be formed using the following photolithography method in combination.

Examples of the photolithography method include a method of combining photoresist patterning with etching such as wet etching using an etchant or dry etching using reactive plasma or a lift-off method.

Examples of another patterning method include a method of irradiating the above-described material with an energy ray such as a laser or an electron beam and polishing the material or changing the conductivity of the material.

Further, for example, a method of transferring a gate electrode-forming composition that is printed on a substrate other than the support can also be used.

The thickness of the gate electrode 20 may be any value and is preferably 1 nm or more and more preferably 10 nm or more. In addition, the thickness of the gate electrode 20 is preferably 500 nm or less and more preferably 200 nm or less.

<Source Electrode and Drain Electrode>

The source electrode 26 is an electrode to which a current flows from the outside through a wiring in the organic thin film transistor. The drain electrode 28 is an electrode from which a current flows to the outside through a wiring, and is typically provided in contact with the organic semiconductor layer 24.

As a material of the source electrode and the drain electrode, a conductive material that is used in an organic thin film transistor in the related art can be used, and examples thereof include the conductive materials described above regarding the gate electrode.

Each of the source electrode and the drain electrode can be formed using the same method as the above-described method of forming the gate electrode.

Using the above-described photolithography method, a lift-off method or an etching method can also be used.

In particular, the source electrode and the drain electrode can also be suitably formed using an etching method. In the etching method, a film is formed using the conductive material, and an unnecessary portion is removed by etching.

In a case where patterning is performed using the etching method, the peeling of the conductive material remaining in the underlayer during resist removal and the reattachment of a resist residue or the removed conductive material to the underlayer can be prevented, and the etching method is excellent from the viewpoint of the shape of an electrode edge portion. From this viewpoint, the etching method is preferable to a lift-off method.

In the lift-off method, a resist is applied to a part of the underlayer, a film is formed on the resist using the conductive material, the resist and the like are eluted or peeled off using a solvent to remove the conductive material on the resist, and the film formed of the conductive material is formed only on a portion where the resist is not applied.

The thickness of each of the source electrode 26 and the drain electrode 28 may be any value and is preferably 1 nm or more and more preferably 10 nm or more. In addition, the thickness of each of the source electrode 26 and the drain electrode 28 is preferably 500 nm or less and more preferably 300 nm or less.

<Organic Semiconductor Layer>

The organic semiconductor layer 24 exhibits semiconductivity and can accumulate carriers. The organic semiconductor layer 24 may be a layer including an organic semiconductor.

The organic semiconductor is not particularly limited, and examples thereof an organic polymer or a derivative thereof and a low molecular weight compound.

In the present invention, the low molecular weight compound refers to a compound other than the organic polymer and the derivative thereof. That is, the low molecular weight compound refers to a compound not including a repeating unit. The molecular weight of the low molecular weight compound is not particularly limited as long as the low molecular weight compound is the above-described compound. The molecular weight of the low molecular weight compound is preferably 300 to 2000 and more preferably 400 to 1000.

Examples of a material of the organic semiconductor layer 24 include a material described in paragraphs "0063" to "0160" of JP2015-170760A. In addition, as the material for forming the organic semiconductor layer 24, an organic semiconductor described in JP2015-195361A and an organic semiconductor described in JP2018-006745A can also be used.

A method of forming the organic semiconductor layer 24 is not particularly limited, and a well-known method of forming an organic semiconductor layer in the related art can be used. For example, a method of dissolving the material for forming the organic semiconductor layer in a solvent, applying the solution to the insulating film, and drying the applied solution to form the semiconductor active layer can be used.

The thickness of the organic semiconductor layer 24 may be any value and is preferably 0.001 μm or more and more preferably 0.01 μm or more. The thickness of the organic semiconductor layer 24 is preferably 1 μm or less and more preferably 0.5 μm or less.

<Inorganic Film (SiNH Film)>

The SiNH film 22 is laminated between the gate electrode 20 and the organic semiconductor layer 24 and insulates the gate electrode 20 and the organic semiconductor layer 24 from each other.

As described above, by using the SiNH film 22 as the insulating film, the insulating film can have higher flexibility than an inorganic film such as a silicon oxide (SiO) film or a silicon nitride (SiN) film that is used as an insulating film in an organic thin film transistor in the related art.

In a case where the SiNH film 22 includes two or more layers, the two or more layers may have the same compositional ratio or different compositional ratios. In addition, the thicknesses may also be the same as or different from each other.

The SiNH film 22 can be formed with a well-known method depending on materials.

For example, plasma CVD such as capacitively coupled plasma (CCP)-CVD or inductively coupled plasma (ICP)-CVD, atomic layer deposition (ALD), sputtering such as magnetron sputtering or reactive sputtering, or various vapor deposition methods such as vacuum deposition can be suitably used.

In particular, plasma CVD such as CCP-CVD or ICP-CVD is suitably used.

<Second Inorganic Film>

The second inorganic film 23 is a thin film including an inorganic compound. The second inorganic film 23 exhibits insulating properties. In addition, by providing the second inorganic film 23, the surface characteristics can be made to be different from those of the SiNH film, and a well-known surface treatment in the related art that is performed on a surface where an organic semiconductor is formed can be performed.

A material of the second inorganic film 23 is not particularly limited, and various inorganic compounds that are used for a well-known organic thin film transistor formed of an inorganic compound exhibiting insulating properties can

be used.

Examples of a material of the second inorganic film 23 include inorganic compounds, for example, a metal oxide such as aluminum oxide, magnesium oxide, tantalum oxide, zirconium oxide, titanium oxide, or indium tin oxide (ITO); a metal nitride such as aluminum nitride; a metal carbide such as aluminum carbide; a silicon oxide such as silicon oxide, silicon oxynitride, silicon oxycarbide, or silicon oxynitride-carbide; a silicon nitride such as silicon nitride or silicon nitride-carbide; a silicon carbide such as silicon carbide; a hydride thereof; a mixture of two or more kinds thereof; and a hydrogen-containing material thereof. In addition, a mixture of two or more kinds of the examples can be used.

The thickness of the second inorganic film 23 is not particularly limited and can be appropriately set depending on materials such that desired insulating properties and surface characteristics can be exhibited.

The thickness of the second inorganic film 23 is preferably 50 nm or less, more preferably 5 to 50 nm, and still more preferably 10 to 30 nm.

It is preferable that the thickness of the second inorganic film 23 is adjusted to be 2 nm or more from the viewpoint of sufficiently obtaining desired insulating properties and surface characteristics. In addition, in a case where the second inorganic film 23 is generally brittle and is excessively thick, cracking, fracturing, peeling, or the like may occur, and bendability deteriorates. However, by adjusting the thickness of the second inorganic film 23 to be 50 nm or less, the occurrence of cracking can be prevented, and deterioration in bendability can be suppressed.

The second inorganic film 23 can be formed using a well-known method depending on materials.

For example, plasma CVD such as capacitively coupled plasma (CCP)-CVD or inductively coupled plasma (ICP)-CVD, atomic layer deposition (ALD), sputtering such as magnetron sputtering or reactive sputtering, or various vapor deposition methods such as vacuum deposition can be suitably used.

In particular, plasma CVD such as CCP-CVD or ICP-CVD is suitably used.

<Organic Layer>

The organic layer 21 functions as an underlayer for appropriately forming the SiNH film 22.

The SiNH film 22 to be formed on the surface of the organic layer 21 is preferably formed by plasma chemical vapor deposition (CVD). Therefore, in a case where the SiNH film 22 is formed, the organic layer 21 is etched by plasma, and a mixed layer or the like including a component of the organic layer 21 and a component of the SiNH film 22 is formed between the organic layer 21 and the SiNH film 22. As a result, the organic layer 21 and the SiNH film 22 adhere to each other with a very strong adhesive strength.

The thickness of the organic layer 21 refers to the thickness of a layer consisting of only the components forming the organic layer 21 without including the above-described mixed layer.

In addition, since the organic layer 21 is an underlayer for appropriately forming the SiNH film 22, the organic layer 21 formed on the surface of the gate electrode 20 is embedded with unevenness of the surface of the gate electrode 20 and the support 12 and foreign matter and the like attached to the surface. As a result, the formation surface of the SiNH film 22 can be appropriately adjusted, and the SiNH film 22 can be appropriately formed.

In addition, in a case where the SiNH film 22 and the organic layer 21 are formed on the gate electrode 20 by transfer, the organic layer 21 is a layer to which a substrate 32 peelably adheres (refer to Fig. 7). That is, the organic layer 21 is peelable from the substrate 32. Accordingly, the adhesive strength between the organic layer 21 and the SiNH film 22 is stronger than the adhesive strength between the substrate 32 and the organic layer 21.

As described above, in a case where the SiNH film 22 is formed by plasma CVD, the organic layer 21 is etched by plasma, the mixed layer is formed, and the adhesive strength between the organic layer 21 and the SiNH film 22 is very high. Accordingly, the adhesive strength between the organic layer 21 and the SiNH film 22 is much stronger than the adhesive strength between the substrate 32 and the organic layer 21. Even in a case where the substrate 32 is peeled off from the organic layer 21, the organic layer 21 and the SiNH film 22 are not peeled off from each other.

By forming the SiNH film 22 on the organic layer 21 from which the substrate 32 is peelable, the transfer type laminated film in which the substrate 32 is peclable is realized.

During the formation of the SiNH film 22, a high temperature is applied to the organic layer 21. Therefore, it is preferable that the organic layer 21 has high heat resistance. Specifically, the glass transition temperature (Tg) of the organic layer 21 is preferably 175°C or higher, more preferably 200°C or higher, and still more preferably 250°C or higher.

As described above, it is preferable that the SiNH film 22 formed on the surface of the organic layer 21 is formed by plasma CVD. It is preferable that Tg of the organic layer 21 is 175°C or higher from the viewpoints that, for example, the etching and volatilization of the organic layer 21 by plasma during the formation of the SiNH film 22 can be suitably suppressed, and the appropriate organic layer 21 and the appropriate SiNH film 22 can be formed.

The upper limit of Tg of the organic layer 21 is not particularly limited and is preferably 500°C or lower.

In addition, due to the same reason as that of Tg, it is preferable that a resin forming the organic layer 21 has a high molecular weight to some extent.

Specifically, the molecular weight (weight-average molecular weight (Mw) of the resin forming the organic layer

21 is preferably 500 or higher, more preferably 1000 or higher, and still more preferably 1500 or higher.

Tg of the organic layer 21 may be specified with a well-known method using a differential scanning calorimeter (DSC) or the like. In addition, the molecular weight may also be measured with a well-known method using gel permeation chromatography (GPC) or the like. In addition, in a case where a commercially available product is used, catalog values may be used as Tg and the molecular weight of the organic layer 21.

Regarding this point, the same can also be applied to the adhesive layer 30 described below.

As a material for forming the organic layer 21, various organic layers (organic layers) that can be used as an underlayer of an inorganic layer in a well-known gas barrier film can be used. The organic layer 21 is formed of, for example, an organic compound obtained by polymerization (crosslinking or curing) of a monomer, a dimer, an oligomer, or the like. The composition for forming the organic layer 21 may include only one organic compound or two or more organic compounds.

The organic layer 21 includes, for example, a thermoplastic resin and an organic silicon compound. Examples of the thermoplastic resin include polyester, a (meth)acrylic resin, a methacrylic acid-maleic acid copolymer, polystyrene, a transparent fluororesin, polyimide, fluorinated polyimide, polyamide, polyamide imide, polyether imide, cellulose acylate, polyurethane, polyether ether ketone, polycarbonate, an alicyclic polyolefin, polyarylate, polyethersulfone, polysulfone, fluorene ring-modified polycarbonate, alicyclic-modified polycarbonate, fluorene ring-modified polyester, and an acrylic compound. Examples of the organic silicon compound include polysiloxane.

From the viewpoints of high strength and glass transition point, it is preferable that the organic layer 21 includes a polymer of a radically curable compound and/or a cationically curable compound having an ether group.

From the viewpoint of reducing the refractive index of the organic layer 21, it is preferable that the organic layer 21 includes a (meth)acrylic resin including, as a major component, a polymer of a monomer, an oligomer, or the like of (meth)acrylate. By reducing the refractive index of the organic layer 21, transparency increases, and light-transmitting property is improved.

It is more preferable that the organic layer 21 includes a (meth)acrylic resin including, as a major component, a monomer, a dimer, an oligomer, or the like of a bifunctional or higher (meth)acrylate such as dipropylene glycol di(meth)acrylate (DPGDA), trimethylolpropane tri(meth)acrylate (TMPTA), or dipentaerythritol hexa(meth)acrylate (DPHA), and it is still more preferable that the organic layer 21 includes a (meth)acrylic resin including, as a major component, a polymer of a monomer or a polymer such as a dimer, an oligomer of a trifunctional or higher (meth)acrylate. In addition, a plurality of (meth)acrylic resins may be used. The major component refers to a component having the highest content mass ratio among components included.

In addition, by forming the organic layer 21 using a resin having an aromatic ring, the substrate 32 can be made peelable.

It is preferable that the organic layer 21 includes, as a major component, a resin including a bisphenol structure. It is preferable that the organic layer 21 includes, as a major component, polyarylate (polyarylate resin (PAR)). As is well known, the polyarylate is an aromatic polyester consisting of a polycondensate of a divalent phenol such as bisphenol represented by bisphenol A and a dibasic acid such as phthalic acid (terephthalic acid or isophthalic acid).

The organic layer 21 includes a resin including a bisphenol structure as a major component, in particular, polyarylate as a major component such that the adhesive strength between the substrate 32 and the organic layer 21 is appropriate and the substrate 32 can be easily peeled. In addition, this configuration is preferable from the viewpoints that, for example, the damage (for example cracking or fracturing) of the SiNH film 22 can be prevented due to appropriate flexibility during the peeling of the substrate 32, the appropriate SiNH film 22 can be stably formed due to high heat resistance, deterioration in performance after transfer can be prevented, and the elasticity of the organic thin film transistor can be improved.

The major component refers to a component having the highest content mass ratio among components included.

In a case where the organic layer 21 is formed of various resins having an aromatic ring, the organic layer 21 may be formed of a commercially available product as long as the commercially available product is a resin having an aromatic ring.

Examples of the commercially available resin for forming the organic layer 21 include UNIFINER (registered trade name) and U-POLYMER (registered trade name) manufactured by Unitika Ltd. and NEOPULIM (registered trade name) manufactured by Mitsubishi Gas Chemical Company Inc.

The organic layer 21 can be formed with a well-known method depending on materials.

For example, the organic layer 21 can be formed with an application method including: dissolving a resin (organic compound) for forming the organic layer 21 in a solvent to prepare a composition (resin composition); applying the composition to the substrate 32; and drying the composition. During the formation of the organic layer 21 using the application method, the resin (organic compound) in the composition may be polymerized (crosslinked) by further irradiating the dried composition with ultraviolet light.

It is preferable that the composition for forming the organic layer 21 includes an organic solvent, a surfactant, and a silane coupling agent in addition to the organic compound.

The thickness of the organic layer 21 is not particularly limited, but the organic layer 21 functions as the underlayer of the SINH film 22. Therefore, in order to form the dense SiNH film 22 having no defects, it is necessary that the organic layer 21 is embedded with unevenness and foreign matter on the formation surface of the SiNH film 22 to make the formation surface of the SiNH film 22 flat. In addition, in a case where the SiNH film 22 is laminated on the gate electrode 20 by transfer, it is necessary to maintain the mechanical strength such that they are not torn off during the peeling of the substrate 32. Therefore, it is necessary that the organic layer 21 is thick to some extent.

From the above-described viewpoint, the thickness of the organic layer 21 is preferably in a range of 0.01 μm to 1 μm, more preferably in a range of 0.03 μm to 0.8 μm, and still more preferably in a range of 0.05 μm to 0.5 μm.

In a case where a plurality of organic layers 21 are formed, the plurality of organic layers 21 may be formed of the same material or different materials. In addition, the thicknesses may also be the same as or different from each other.

In addition, in a case where the SiNH film 22 is laminated on the gate electrode 20 by transfer, it is necessary that the organic layer 21 is formed to be peelable from the substrate 32. Therefore, as described above, a material having peelability may be used as the material of the organic layer 21, and a peeling layer may be provided between the organic layer 21 and the substrate 32. As the peeling layer, a well-known peeling layer in the release layer can be appropriately used.

<Adhesive Layer>

In a case where the SiNH film 22 is laminated on the gate electrode 20 by transfer, the adhesive layer 30 bonds the transfer layer including the SiNH film 22 and the organic layer 21 to the gate electrode 20. The adhesive layer 30 is formed between the SiNH film 22 and the gate electrode 20 and the support 12 to embed the gate electrode 20.

In addition, the adhesive layer 30 also acts as a protective layer that protects the SiNH film 22 exhibiting insulating properties.

The adhesive layer 30 may be a well-known optical clear adhesive (OCA) in the related art or may be an adhesive layer formed of a hot melting adhesive (HMA). Specifically, the hot melting adhesive layer is an adhesive layer that is solid at a normal temperature and flows to exhibit adhesiveness during heating. In the present invention, the normal temperature refers to 23°C.

In a case where the hot melting adhesive is used, it is preferable that the adhesive layer 30 flows to exhibit adhesiveness at 30°C to 200°C, it is more preferable that the adhesive layer 30 flows to exhibit adhesiveness at 40°C to 180°C, and it is still more preferable that the adhesive layer 30 flows to exhibit adhesiveness at 50°C to 150°C.

In a case where the adhesive layer 30 flows to exhibit adhesiveness at a normal temperature, the above-described foil peeling is likely to occur during the cutting and transfer of the transfer type laminated film, and deterioration in insulating performance occurs.

In addition, in a case where the temperature at which the adhesive layer flows to exhibit adhesiveness is excessively high, a heating temperature required for adhesion to an adhesion target increases, and thermal damage is applied to the substrate 32, the organic layer 21, and the adhesion target.

In a case where the hot melting adhesive is used, Tg of the adhesive layer 30 is not particularly limited and is preferably 130°C or lower, more preferably 100°C or lower, still more preferably 60°C or lower, and still more preferably 30°C or lower.

It is preferable that Tg of the adhesive layer 30 is 130°C or lower from the viewpoints that, for example, since heat fluidity can be easily obtained, adhesiveness and transfer characteristics during heating are improved, the above-described foil peeling can be prevented, adhesion can be performed at a low temperature, and productivity can be improved.

The lower limit of Tg of the adhesive layer 30 is not particularly limited and is preferably -150°C or higher.

In a case where the hot melting adhesive is used, a material of the adhesive layer 30 is not particularly limited as long as it is solid at a normal temperature and flows to exhibit adhesiveness during heating.

In a case where the hot melting adhesive is used, it is preferable that the adhesive layer 30 includes an amorphous resin as a major component, it is more preferable that the adhesive layer 30 includes an acrylic resin as a major component, and it is still more preferable that the adhesive layer 30 includes a resin (acrylic homopolymer (homoacrylic polymer)) obtained by polymerization of a single acrylate monomer as a major component.

It is preferable that the adhesive layer 30 includes an amorphous resin, in particular, an acrylic resin as the major component from the viewpoint that, for example, a gas barrier film having high transparency can be obtained.

Further, it is preferable that the adhesive layer 30 includes an acrylic homopolymer as the major component not only in consideration of the above-described advantageous effects but also from the viewpoints that, for example, transfer characteristics by heat can be improved, foil peeling can be prevented, and blocking can be suppressed during winding after curing. In addition, by forming the adhesive layer 30 using the acrylic homopolymer, in addition to the above-described advantageous effects, the adhesive layer 30 can be made flow to exhibit adhesiveness at a relatively low temperature. Accordingly, in a case where high heat resistance is not required for the laminated film, the adhesive

layer 30 formed of the acrylic homopolymer is suitably used.

In a case where the hot melting adhesive is used, various well-known resins or commercially available products can be used as long as they can form the adhesive layer 30 that is solid at a normal temperature and flows to exhibit adhesiveness during heating.

Specifically 0415BA (acrylic homopolymer) and #7000 series manufactured by Taisei Fine Chemical Co., Ltd. can be used.

Optionally, the adhesive layer 30 may include one or more selected from the group consisting of a styrene acrylic copolymer (styrene-modified acrylic resin), a urethane acrylic copolymer (urethane-modified acrylic resin), and an acrylic resin for adjusting the glass transition point.

By adding these components to the adhesive layer 30, Tg of the adhesive layer 30 can be improved. Accordingly, in a case where heat resistance is required for the organic thin film transistor depending on the use and the like, the adhesive layer 30 to which the above-described components are added is suitably used.

In addition, by adding a styrene acrylic copolymer to the adhesive layer 30, the hardness of the adhesive layer 30 can be adjusted, and a balance with the hardness of the adhesion target can be adjusted. By adding a urethane acrylic copolymer to the adhesive layer 30, the adhesiveness with the SiNH film 22 can be improved.

The addition amounts of the components are not particularly limited and may be appropriately determined depending on the components to be added and desired Tg. However, it is preferable that the addition amounts of the components are adjusted such that the major component of the adhesive layer 30 is the amorphous resin, the acrylic resin, or the like described above.

The styrene acrylic copolymer, the urethane acrylic copolymer, and the acrylic resin for adjusting the glass transition point are not particularly limited, and various resins that are used for adjusting Tg of a resin or the like can be used. In addition, as the components, a commercially available product can also be used.

Examples of the styrene acrylic copolymer include #7000 series manufactured by Taisei Fine Chemical Co., Ltd.

Examples of the urethane acrylic copolymer include ACRYT (registered trade name) 8UA series manufactured by Taisei Fine Chemical Co., Ltd.

Examples of the acrylic resin for adjusting the glass transition point include PMMA (DIANAL (registered trade name) manufactured by Mitsubishi Chemical Corporation.

The thickness of the adhesive layer 30 is not particularly limited, and from the viewpoint of obtaining sufficient adhesiveness, it is necessary that the thickness of the adhesive layer 30 is large to some extent. In addition, from the viewpoint of realizing a reduction in the weight and thickness of the organic thin film transistor as a whole, it is preferable that the thickness of the adhesive layer 30 is as small as possible.

From the above-described viewpoint, the thickness of the adhesive layer is preferably in a range of 20 μm to 0.1 μm, more preferably in a range of 5 μm to 0.3 μm, and still more preferably in a range of 2 μm to 0.5 μm.

[Method of Manufacturing Organic Thin Film Transistor]

A method of manufacturing an organic thin film transistor according to the embodiment of the present invention comprises:

a gate electrode forming step of forming a gate electrode on a support;
an insulating film laminating step of laminating an insulating film on the gate electrode;
an organic semiconductor layer forming step of forming an organic semiconductor layer on the insulating film; and
a source-drain electrode forming step of forming a source electrode and a drain electrode on the organic semiconductor layer,
in which the insulating film includes an inorganic layer consisting of SiNH.

Hereinafter, an example of the method of manufacturing the organic thin film transistor according to the embodiment of the present invention will be described with reference to the conceptual diagrams shown in Figs. 5 to 10. As shown in Fig.3, the manufacturing method described below is a method of manufacturing the organic thin film transistor 10c in which the adhesive layer 30 and the organic layer 21 are provided below and above the SiNH film 22, respectively.

First, in the gate electrode forming step, as shown in Fig. 5, the gate electrode is formed on the support 12. The material and the method for forming the gate electrode 20 are as described above.

Next, in the insulating film laminating step, the insulating film is laminated on the gate electrode 20.

First, as shown in Fig. 6, the adhesive layer 30 is formed on the gate electrode 20.

On the other hand, as shown in Fig. 7, a transfer type laminated film 40 including the substrate 32 and the transfer layer that includes the organic layer 21 and the SiNH film 22 is prepared. In the transfer type laminated film 40, the substrate 32 is peelable from the transfer layer.

As the substrate 32, a well-known sheet-shaped material (a film or a plate-shaped material) that is used as a

substrate (support) for various laminated functional films, and the like can be used. In addition, as the substrate 32, various sheet-shaped materials that are used as separators (a light peeling separator and a heavy peeling separator) for various optical clear adhesives (OCA) can also be used.

The transfer type laminated film 40 can be prepared by forming the organic layer 21 on the substrate 32 using the above-described method and further forming the SiNH film 22 on the organic layer 21 using the above-described method.

In addition, the transfer type laminated film 40 may include a protective film that is provided on the SiNH film 22. In a case where the transfer type laminated film 40 includes the protective film, the protective film only has to be peeled off before transfer.

As shown in Fig. 8, the transfer type laminated film 40 is laminated such that the SiNH film 22 side adheres to the adhesive layer 30. Optionally heating, pressure bonding, or the like may be performed.

Next, as shown in Fig. 9, the substrate 32 is peeled, and the SINH film 22 as the insulating film is laminated on the gate electrode.

Next, as shown in Fig. 10, in the organic semiconductor layer forming step, the organic semiconductor layer 24 is formed on the organic layer 21 above the SiNH film 22. As described above, the organic semiconductor layer 24 can be formed using the well-known method in the related art.

Next, in the source-drain electrode forming step, the source electrode 26 and the drain electrode 28 are formed on the organic semiconductor layer 24. As described above, the source electrode 26 and the drain electrode 28 can be formed using a well-known method in the related art. As a result, the organic thin film transistor 10c shown in Fig. 3 is prepared.

In the above-described example, in the insulating film laminating step, using the transfer type laminated film including the SiNH film 22 and the organic layer 21 above the substrate 32, the SiNH film 22 and the organic layer 21 are transferred and laminated on the gate electrode 20. However, the present invention is not limited to this configuration.

For example, in the insulating film laminating step, the SiNH film 22 may be directly formed on the gate electrode 20. Alternatively, the organic layer 21 may be formed on the gate electrode 20, and the SiNH film 22 may be formed on the organic layer 21.

In addition, in the method of manufacturing the organic thin film transistor, the respective steps may be performed by roll-to-roll (R-to-R), or may be performed in a batch type using the cut transfer type laminated film. In addition, all of the preparation of the transfer type laminated film 40 and the steps of the method of manufacturing the organic thin film transistor may be performed by a series of R-to-R.

Hereinabove, the organic thin film transistor according to the embodiment of the present invention and the method of manufacturing the organic thin film transistor have been described in detail. However, the present invention is not limited to the above-described aspects, and various improvements or changes may be made within a range not departing from the scope of the present invention.

## Examples

Hereinafter, the present invention will be described in detail using Examples. The present invention is not limited to the following specific examples.

### [Example 1]

<Preparation of Organic Thin Film Transistor>

As the support 12, PEN (manufactured by Teijin Film Solutions Ltd.) having a thickness of 0.1 mm was used, and the organic thin film transistor shown in Fig. 1 was prepared as follows.

(Formation of Gate Electrode)

Gold was deposited on the glass substrate by vacuum deposition to form the gate electrode 20. The gate electrode 20 had a width of 10 mm and a thickness of 50 nm.

(Formation of Insulating Film)

Using a CVD apparatus, the SINH film was formed on the support 12 on which the gate electrode 20 was formed.

For example, the CVD apparatus includes a CCP-CVD film forming device, a drum as a facing electrode that winds and transports the substrate, a guide roller that peels the protective film laminated on the resin layer, a collection roll that winds the peeled protective film, a charging portion into which a roll of the elongated protective film is charged,

and a guide roller that laminates the protective film on the surface of the formed inorganic layer. As the CVD apparatus, an apparatus including two or more film forming units (film forming devices) was used.

The support 12 on which the gate electrode 20 was formed was unwound from the roll charged into the charging portion to form the SiNH film 22. In order to form the SiNH film 22, two electrodes (film forming units) were used, and silane gas, ammonia gas, and hydrogen gas were used as raw material gases. In the first film forming unit, the amounts of supply of the raw material gases were silane gas: 150 sccm, ammonia gas: 300 sccm, and hydrogen gas: 800 sccm. In the second film forming unit, the amounts of supply of the raw material gases were silane gas: 150 sccm, ammonia gas: 350 sccm, and hydrogen gas: 800 sccm. In the first film forming unit and the second film forming unit, the plasma excitation power was 2.5 kW, and the frequency of the plasma excitation power was 13.56 MHz. A bias power of 0.5 kW having a frequency of 0.4 MHz was applied to the drum. In addition, the temperature of the drum was controlled to 30°C by a cooling unit. The deposition pressure was 50 Pa. The thickness of the SiNH film 22 was 20 nm.

In addition, in a case where the ratio SiN:H of the number of SiN atoms to the number of H atoms in the SINH film 22 was measured by RBS/HFS using a Rutherford backscattering spectrometer (HRBS-V500, manufactured by Kobe Steel Ltd.), SiN:H was 1:1.2.

(Formation of Organic Semiconductor Layer)

A toluene solution in which the organic semiconductor b shown below was dissolved at a concentration of 0.5 wt% was prepared. This solution was spin-coated on the SiNH film 22 (at 500 rpm for 20 seconds and at 1000 rpm for 20 seconds), and the organic semiconductor layer 24 was formed such that the thickness of the layer after drying was 150 nm.

Organic Semiconductor b

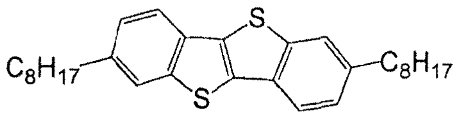

(Formation of Source Electrode and Drain Electrode)

Gold was vacuum-deposited on the organic semiconductor layer 24 to form the source electrode 26 and the drain electrode 28. In each of the source electrode 26 and the drain electrode 28, the channel length was 30 μm, the thickness was 50 nm, and the channel width was 10 mm.

Through the above-described steps, the organic thin film transistor was prepared.

[Example 2]

The organic thin film transistor shown in Fig. 2 was prepared using the same method as that of Example 1, except that the organic layer 21 was formed through the following step before forming the SiNH film 22.

(Organic Layer Forming Step)

TMPTA (manufactured by Daicel-Allnex Ltd.) and a photopolymerization initiator (ESACURE (registered trade name) KTO 46, manufactured by Lamberti S.p.A.) were prepared and were weighed such that a weight ratio thereof was 95:5. These components were dissolved in methyl ethyl ketone. As a result, a coating solution having a concentration of solid contents of 15% was obtained. Using a spin coater, this coating solution was applied to the support 12 on which the gate electrode 20 was formed, and was dried at 50°C for 3 minutes. Next, the coating solution was irradiated with ultraviolet light (cumulative irradiation dose: about 600 mJ/$cm^2$) to be cured. The thickness of the organic layer 21 was 0.5 μm.

Next, the SiNH film 22 was formed on the organic layer 21 using the same method as that of Example 1.

[Example 3]

The organic thin film transistor shown in Fig. 3 was prepared using the same method as that of Example 1, except that the SiNH film 22 was laminated by transfer.

<Preparation of transfer type laminated film>

As the substrate 32, a PET film (manufactured by Toyobo Co., Ltd., A4100, thickness: 100 μm, width: 1000 mm, length: 100 m) was used, the organic layer 21 and the SiNH film 22 were formed on a non-coated surface in the following procedure, and the transfer type laminated film 40 was prepared.

(Formation of Organic Layer)

Polyarylate (manufactured by Unitika Ltd., UNIFINER (registered trade name) M-2000H) and cyclohexanone were prepared, were weighted at a weight ratio of 5:95, and were dissolved at a normal temperature to prepare a coating solution having a concentration of solid contents of 5%. Tg of the used polyarylate was 275°C (catalog value).

This coating solution was applied to the above-described substrate 32 by R-to-R using a die coater, and the substrate was allowed to pass through a drying zone at 130°C for 3 minutes. Before contact with an initial film surface touch roll, a polyethylene (PE) protective film was bonded, and then the laminate was wound. The thickness of the organic layer 21 formed on the substrate 32 was 0.5 μm.

(Formation of SiNH film)

Using a general R-to-R CVD apparatus that winds the substrate around a drum for film formation, the SiNH film 22 was formed on the surface of the organic layer 21.

For example, the CVD apparatus includes a CCP-CVD film forming device, a drum as a facing electrode that winds and transports the substrate, a guide roller that peels the protective film laminated on the resin layer, a collection roll that winds the peeled protective film, a charging portion into which a roll of the elongated protective film is charged, and a guide roller that laminates the protective film on the surface of the formed inorganic layer. As the CVD apparatus, an apparatus including two or more film forming units (film forming devices) was used.

The substrate 32 on which the organic layer 21 was formed was unwound from the roll charged into the charging portion, the protective film was peeled off after passing through a final film surface touch roll before film formation, and the SiNH film 22 was formed on the exposed organic layer 21. In order to form the SiNH film 22, two electrodes (film forming units) were used, and silane gas, ammonia gas, and hydrogen gas were used as raw material gases. In the first film forming unit, the amounts of supply of the raw material gases were silane gas: 150 sccm, ammonia gas: 300 sccm, and hydrogen gas: 800 sccm. In the second film forming unit, the amounts of supply of the raw material gases were silane gas: 150 sccm, ammonia gas: 350 sccm, and hydrogen gas: 800 sccm. In the first film forming unit and the second film forming unit, the plasma excitation power was 2.5 kW, and the frequency of the plasma excitation power was 13.56 MHz. A bias power of 0.5 kW having a frequency of 0.4 MHz was applied to the drum. In addition, the temperature of the drum was controlled to 30°C by a cooling unit. The deposition pressure was 50 Pa. The PE protective film was bonded to the surface of the SiNH film 22 immediately after the formation, and the laminate was wound. The thickness of the SiNH film 22 was 20 nm.

In addition, SiN:H was 1:1.2.

<Transfer of SiNH Film>

The substrate 32 was peeled off from the transfer type laminated film 40 prepared as described above, the SiNH film 22 and the organic layer 21 was bonded to the gate electrode 20 using the adhesive such that the organic layer 21 side faced the gate electrode side.

[Example 4]

An organic thin film transistor was prepared using the same method as that of Example 1, except that conditions for forming the SINH film 22 were changes as follows.

In the first film forming unit, the amounts of supply of the raw material gases were silane gas: 150 sccm, ammonia gas: 300 sccm, and hydrogen gas: 500 sccm. In the second film forming unit, the amounts of supply of the raw material gases were silane gas: 150 sccm, ammonia gas: 350 sccm, and hydrogen gas: 500 sccm. In the first film forming unit and the second film forming unit, the plasma excitation power was 2.5 kW, and the frequency of the plasma excitation power was 13.56 MHz. A bias power of 0.5 kW having a frequency of 0.4 MHz was applied to the drum.

The thickness of the SiNH film 22 was 20 nm. In addition, the ratio SiN:H of the number of SiN atoms to the number of H atoms in the SINH film 22 was 1:0.75.

[Example 5]

An organic thin film transistor was prepared using the same method as that of Example 1, except that conditions for forming the SINH film 22 were changes as follows.

In the first film forming unit, the amounts of supply of the raw material gases were silane gas: 150 sccm, ammonia gas: 100 sccm, and hydrogen gas: 1000 sccm. In the second film forming unit, the amounts of supply of the raw material gases were silane gas: 150 sccm, ammonia gas: 100 sccm, and hydrogen gas: 1000 sccm. In the first film forming unit and the second film forming unit, the plasma excitation power was 2.5 kW, and the frequency of the plasma excitation power was 13.56 MHz. A bias power of 0.5 kW having a frequency of 0.4 MHz was applied to the drum.

The thickness of the SiNH film 22 was 20 nm. In addition, the ratio SiN:H of the number of SiN atoms to the number of H atoms in the SINH film 22 was 1:1.8.

[Example 6]

An organic thin film transistor was prepared using the same method as that of Example 1, except that conditions for forming the SINH film 22 were changes as follows.

In the first film forming unit, the amounts of supply of the raw material gases were silane gas: 75 sccm, ammonia gas: 180 sccm, and hydrogen gas: 300 sccm. In the second film forming unit, the amounts of supply of the raw material gases were silane gas: 75 sccm, ammonia gas: 180 sccm, and hydrogen gas: 300 sccm. In the first film forming unit and the second film forming unit, the plasma excitation power was 2.5 kW, and the frequency of the plasma excitation power was 13.56 MHz. A bias power of 0.5 kW having a frequency of 0.4 MHz was applied to the drum.

The thickness of the SiNH film 22 was 9 nm. In addition, SiN:H was 1:1.2.

[Example 7]

An organic thin film transistor was prepared using the same method as that of Example 1, except that the $SiO_2$ film 23 was provided on the SiNH film 22.

In a third film forming unit of the CVD apparatus that was used for forming the SiNH film 22 after the formation of the SiNH film 22, the SiOz film was formed on the SiNH film 22.

In the third film forming unit, the amounts of supply of the raw material gases were silane gas: 150 sccm, ammonia gas: 300 sccm, and hydrogen gas: 0 sccm. In the third film forming unit, the plasma excitation power was 2.5 kW, and the frequency of the plasma excitation power was 13.56 MHz. The surface was exposed to air and oxidized to obtain the $SiO_2$ film.

The thickness of the SiOz film 23 was 2 nm.

[Comparative Example 1]

An organic thin film transistor was prepared using the same method as that of Example 1, except that the SiN film was formed as the insulating film.

(Formation of SiN film)

Using a general R-to-R CVD apparatus that winds the substrate around a drum for film formation, the SiN film was formed on the surface of the organic layer 21.

The support 12 on which the gate electrode 20 was formed was unwound from the roll charged into the charging portion to form the SiN film. In order to form the SiN film, two electrodes (film forming units) were used, and silane gas, ammonia gas, and nitrogen gas were used as raw material gases. In the first film forming unit, the amounts of supply of the raw material gases were silane gas: 150 sccm, ammonia gas: 300 sccm, and nitrogen gas: 100 sccm. In the second film forming unit, the amounts of supply of the raw material gases were silane gas: 150 sccm, ammonia gas: 350 sccm, and nitrogen gas: 500 sccm. In the first film forming unit and the second film forming unit, the plasma excitation power was 2.5 kW, and the frequency of the plasma excitation power was 13.56 MHz. A bias power of 0.5 kW having a frequency of 0.4 MHz was applied to the drum. In addition, the temperature of the drum was controlled to 30°C by a cooling unit. The deposition pressure was 50 Pa. The thickness of the SiN film was 20 nm.

[Evaluation]

<Carrier Mobility>

Regarding the organic thin film transistor according to each of Examples and Comparative Example prepared as described above, the carrier mobility was evaluated using the following method.

A voltage of -40 V was applied between the source electrode and the drain electrode, a gate voltage was caused to vary in a range of +40 V to -40 V, and a carrier mobility $\mu$ was calculated using the following expression indicating a drain current Id.

$$Id = (w / 2L)\mu Ci(Vg - Vth)^2$$

(in the expression, L represents a gate length, w represents a gate width, Ci represents a volume of the insulating layer per unit area, Vg represents a gate voltage, and Vth represents a threshold voltage)

<Bendability>

After outwardly bending the organic thin film transistor according to each of Examples and Comparative Example by $\Phi$ 8 mm 100,000 times, the carrier mobility (in Table 1, "Mobility") was measured as described above, and a ratio thereof to the carrier mobility before the bending test was calculated.

The results are shown in the following table.

[Table 1]

| | Inorganic Film | | | Second inorganic Film | Organic Layer | Transfer | Evaluation | | |
|---|---|---|---|---|---|---|---|---|---|
| | Kind | Thickness nm | SiN:H | Kind | | | Carrier Mobility | Bendability | |
| | | | | | | | | Mobility | Ratio |
| Example 1 | SiNH | 20 | 1:1.2 | - | None | - | 0.050 | 0.045 | 90% |
| Example 2 | SiNH | 20 | 1:1.2 | - | Provided | - | 0.080 | 0.080 | 100% |
| Example 3 | SiNH | 20 | 1:1.2 | - | Provided | Transfer | 0.110 | 0.110 | 100% |
| Example 4 | SiNH | 20 | 1:0.75 | - | None | - | 0.450 | 0.445 | 99% |
| Example 5 | SiNH | 20 | 1:1.8 | - | None | - | 0.470 | 0.460 | 98% |
| Example 6 | SiNH | 9 | 1:1.2 | - | None | - | 0.040 | 0.039 | 98% |
| Example 7 | SiNH | 20 | 1:1.2 | $SiO_2$ | None | - | 0.100 | 0.090 | 90% |
| Comparative Example 1 | SiN | 20 | - | - | None | - | 0.020 | 0.001 | 5% |

It can be seen from Table 1 that, in the organic thin film transistor according to the embodiment of the present invention, a decrease in carrier mobility after the bending test is small, and bendability is high as compared to Comparative Example.

In addition, it can be seen from a comparison between Examples 1 and 2 that it is preferable that the organic layer as the underlayer of the inorganic film is provided.

In addition, it can be seen from a comparison between Examples 2 and 3 that it is preferable that the inorganic film is laminated by transfer.

In addition, it can be seen from a comparison between Examples 1, 4, and 5 that the ratio SiN:H of the number of SiN atoms to the number of H atoms is more preferably 1:0.9 to 1.5.

It can be seen from a comparison between Examples 1 and 6 that the thickness of the inorganic film is preferably 10 nm or more.

In addition, it can be seen from a comparison between Examples 1 and 7 that it is preferable that the second inorganic film is provided.

As can be seen from the above results, the effects of the present invention are obvious.

Explanation of References

10, 10a to 10d: organic thin film transistor
12: support
18: transistor element
20: gate electrode
21: organic layer
22: SiNH film (inorganic film, insulating film)
23: second inorganic film ($SiO_2$ film)
24: organic semiconductor layer
26: source electrode
28: drain electrode
30: resin layer
32: substrate
40: transfer type laminated film

## Claims

1. An organic thin film transistor (10a, 10b, 10c, 10d) comprising:

   a gate electrode (20);
   an insulating film that is formed to cover the gate electrode (20);
   an organic semiconductor layer (24) that is formed on the insulating film; and
   a source electrode (26) and a drain electrode (28) that are formed on the organic semiconductor layer (24),
   wherein the insulating film includes an inorganic film (22) consisting of SiNH, **characterized in that** the ratio SiN:H of the number of SiN atoms to the number of H atoms in the inorganic film (22) is 1:0.7 to 2.

2. The organic thin film transistor according to claim 1,
   wherein a thickness of the inorganic film (22) is 1 nm to 100 nm.

3. The organic thin film transistor (10b) according to claim 1 or 2,
   wherein an organic layer (21) is provided on the gate electrode (20) side of the inorganic film (22).

4. The organic thin film transistor according to claim 3,
   wherein a thickness of the organic layer (21) is 0.01 μm to 1 μm.

5. The organic thin film transistor according to claim 3 or 4,
   wherein a glass transition temperature of the organic layer (21) is 200°C or higher.

6. The organic thin film transistor (10d) according to any one of claims 1 to 5,

wherein a second inorganic film (23) consisting of $SiO_2$ is provided on a surface on the organic semiconductor layer (24) side of the inorganic film (22).

7. The organic thin film transistor according to any one of claims 1 to 6, wherein a support (12) that supports the gate electrode (20), the insulating film, the organic semiconductor layer (24), the source electrode (26), and the drain electrode (28) is provided.

8. A method of manufacturing the organic thin film transistor (10a, 10b, 10c, 10d) according to any one of claims 1 to 7, the method comprising:

   a gate electrode (20) forming step of forming a gate electrode (20) on a support (12);
   an insulating film laminating step of laminating an insulating film on the gate electrode (20);
   an organic semiconductor layer (24) forming step of forming an organic semiconductor layer (24) on the insulating film; and
   a source-drain electrode forming step of forming a source electrode (26) and a drain electrode (28) on the organic semiconductor layer (24),
   wherein the insulating film includes an inorganic layer (22) consisting of SiNH.

9. The method of manufacturing the organic thin film transistor according to claim 8, wherein in the insulating film laminating step, a transfer type laminated film (40) including a substrate (32) and a transfer layer that includes the inorganic layer (22) formed on the substrate (32) is laminated on the gate electrode (20) and subsequently the substrate (32) is peeled off from the transfer layer such that the insulating film is laminated on the gate electrode (20).

**Patentansprüche**

1. Organischer Dünnschichttransistor (10a, 10b, 10c, 10d), umfassend:

   eine Gate-Elektrode (20);
   eine Isolierschicht, die gebildet ist, um die Gate-Elektrode (20) abzudecken;
   eine organische Halbleiterschicht (24), die auf der Isolierschicht ausgebildet ist; und
   eine Source-Elektrode (26) und eine Drain-Elektrode (28), die auf der organischen Halbleiterschicht (24) gebildet sind,
   wobei die Isolierschicht eine anorganische Schicht (22) aufweist, die aus SiNH besteht,
   **dadurch gekennzeichnet, dass** das Verhältnis SiN:H der Anzahl von SiN-Atome zu der Anzahl von H-Atomen in der anorganischen Schicht (22) 1:0,7 bis 2 beträgt.

2. Organischer Dünnschichttransistor nach Anspruch 1, bei dem eine Dicke der anorganischen Schicht (22) 1 nm bis 100 nm beträgt.

3. Der organische Dünnschichttransistor (10b) nach Anspruch 1 oder 2, bei dem eine organische Schicht (21) auf der Seite der Gate-Elektrode (20) der anorganischen Schicht (22) vorhanden ist.

4. Organischer Dünnschichttransistor nach Anspruch 3, bei dem eine Dicke der organischen Schicht (21) 0,01 $\mu$m bis 1 $\mu$m beträgt.

5. Organischer Dünnschichttransistor nach Anspruch 3 oder 4, bei dem eine Glasübergangstemperatur der organischen Schicht (21) 200°C oder mehr beträgt.

6. Organischer Dünnschichttransistor (10d) nach einem der Ansprüche 1 bis 5, bei dem eine zweite anorganische Schicht (23), auch aus SiO2, auf einer Oberfläche auf der Seite der anorganischen Halbleiterschicht (24) der anorganischen Schicht (22) vorhanden ist.

7. Organischer Dünnschichttransistor nach einem der Ansprüche 1 bis 6, bei dem ein Träger (12), der die Gate-Elektrode (20), die Isolierschicht, die organische Halbleiterschicht (24), die Source-Elektrode (26) und die Drain-Elektrode (28) trägt, vorhanden ist.

**8.** Verfahren zum Fertigen des organischen Dünnschichttransistors (10a, 10b, 10c, 10d) nach einem der Ansprüche 1 bis 7, umfassend:

einen Erzeugungsschritt zum bilden einer Gate-Elektrode (20) auf einem Träger (12);
einen Isolierschicht-Laminierschritt des Laminieres einer Isolierschicht auf der Gate-Elektrode (20);
einen Erzeugungsschritt zum Bilden einer organischen Halbleiterschicht (24) auf der Isolierschicht; und
einen Erzeugungsschritt zum Bilden einer Source-Elektrode (24) und einer Drain-Elektrode (28) auf der organischen Halbleiterschicht (24),
wobei die Isolierschicht eine anorganische Schicht (22) aus SiNH enthält.

**9.** Verfahren zum Fertigen des organischen Dünnschichttransistors nach Anspruch 8,
bei dem in dem Isolierschicht-Laminierschritt eine Laminierschicht (40) vom Transfer-Typ mit einem Substrat (32) und eine Transferschicht, welche die anorganische Schicht (22) enthält, die auf dem Substrat (32) gebildet ist, auf die Gate-Elektrode (20) auflaminiert wird und anschließend das Substrat (32) von der Transferschicht abgeschält wird, so dass die Isolierschicht auf der Gate-Elektrode (20) laminiert ist.

## Revendications

**1.** Transistor à couches minces organique (10a, 10b, 10c, 10d), comprenant :

une électrode de grille (20) ;
un film isolant, lequel est formé pour couvrir l'électrode de grille (20) ;
une couche semi-conductrice organique (24), laquelle est formée sur le film isolant, et
une électrode de source (26) et une électrode de drain (28), lesquelles sont formées sur la couche semi-conductrice organique (24),
dans lequel le film isolant inclut un film inorganique (22) consistant en SiNH,
**caractérisé en ce que** le rapport SiN : H entre le nombre d'atomes SiN et le nombre d'atomes H dans le film inorganique (22) est égal à 1 : 0,7 à 2.

**2.** Transistor à couches minces organique selon la revendication 1,
dans lequel une épaisseur du film organique (22) s'étend de 1 nm à 100 nm.

**3.** Transistor à couches minces organique (10b) selon la revendication 1 ou 2,
dans lequel une couche organique (21) est prévue sur le côté électrode de grille (20) du film inorganique (22).

**4.** Transistor à couches minces organique selon la revendication 3,
dans lequel une épaisseur de la couche organique (21) s'étend de 0,01 $\mu$m à 1 $\mu$m .

**5.** Transistor à couches minces organique selon la revendication 3 ou 4,
dans lequel une température de transition vitreuse de la couche organique (21) est supérieure ou égale à 200 °C.

**6.** Transistor à couches minces organique (10d) selon l'une quelconque des revendications 1 à 5,
dans lequel un second film inorganique (23) consistant en $SiO_2$ est prévu sur une surface sur le côté couche semi-conductrice organique (24) du film inorganique (22).

**7.** Transistor à couches minces organique selon l'une quelconque des revendications 1 à 6,
dans lequel il est prévu un support (12), lequel supporte l'électrode de grille (20), le film isolant, la couche semi-conductrice organique (24), l'électrode de source (26) et l'électrode de drain (28).

**8.** Procédé de fabrication du transistor à couches minces organique (10a, 10b, 10c, 10d) selon l'une quelconque des revendications 1 à 7, le procédé comprenant les étapes suivantes :

une étape pour former l'électrode de grille (20) pour former une électrode de grille (20) sur un support (12) ;
une étape pour laminer un film isolant, pour laminer un film isolant sur l'électrode de grille (20) ;
une étape pour former une couche semi-conductrice organique (24), pour former une couche semi-conductrice organique (24) sur le film isolant, et
une étape pour former une électrode source-drain, pour former une électrode de source (26) et une électrode

de drain (28) sur la couche semi-conductrice organique (24), dans lequel le film isolant inclut une couche inorganique (22) consistant en du SiNH.

**9.** Procédé de fabrication du transistor à couches minces organique selon la revendication 8, dans lequel lors de l'étape pour laminer un film isolant, un film laminé de type à transfert (40) incluant un substrat (32) et une couche de transfert, laquelle inclut la couche inorganique (22) formée sur le substrat (32), est laminé sur l'électrode de grille (20), puis le substrat (32) est détaché de la couche de transfert de telle sorte que le film isolant est laminé sur l'électrode de grille (20).

FIG. 1

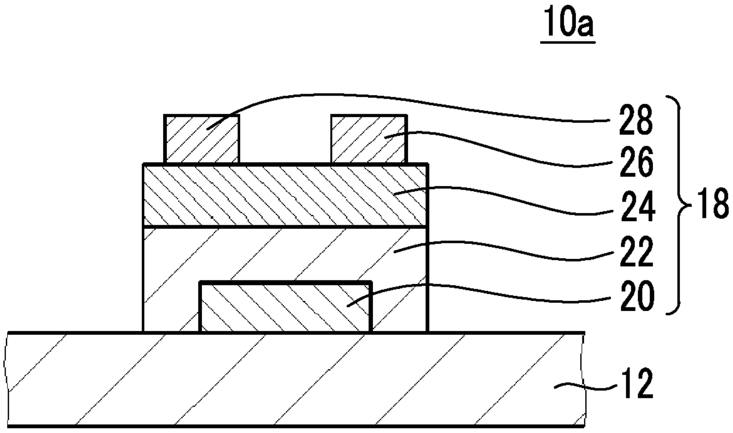


FIG. 2

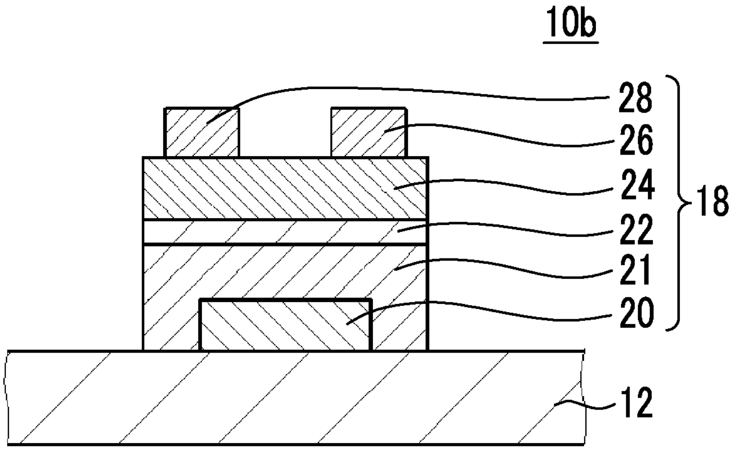


FIG. 3

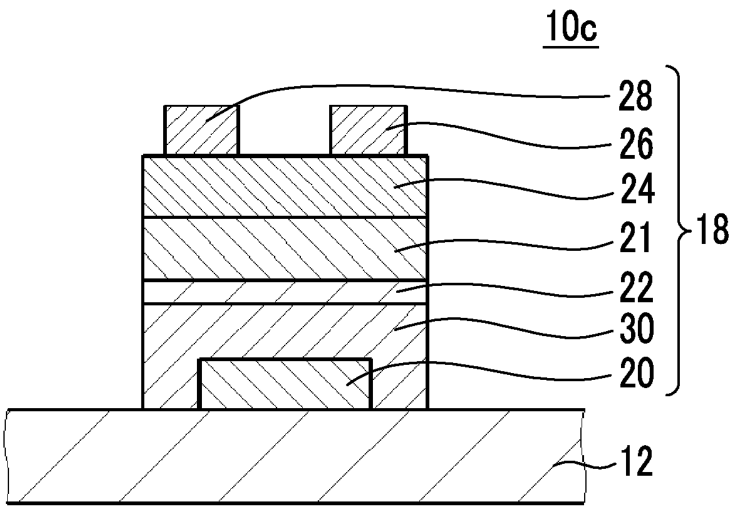

FIG. 4

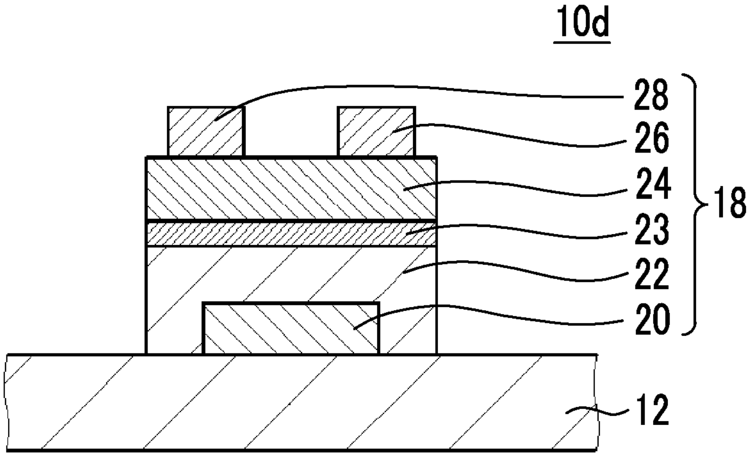


FIG. 5

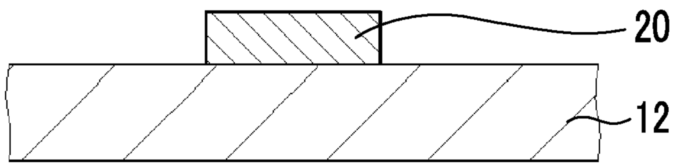


FIG. 6

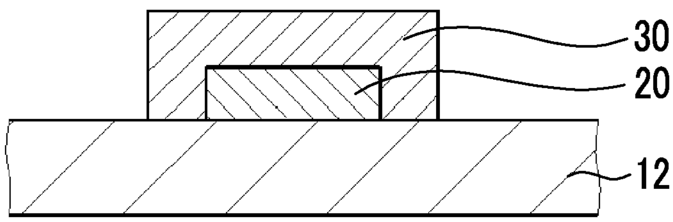


FIG. 7

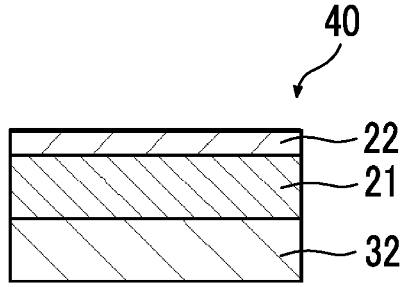

FIG. 8

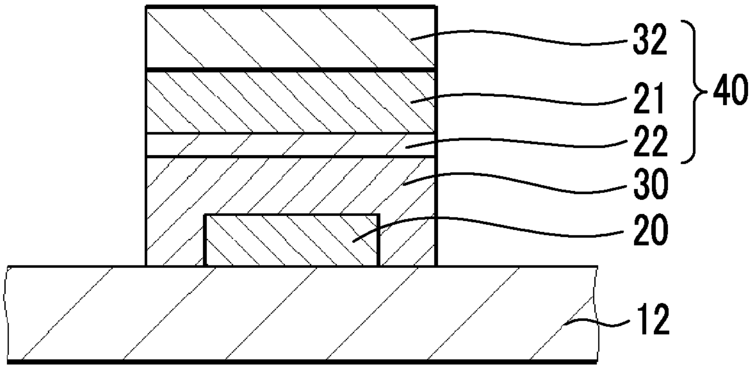


FIG. 9

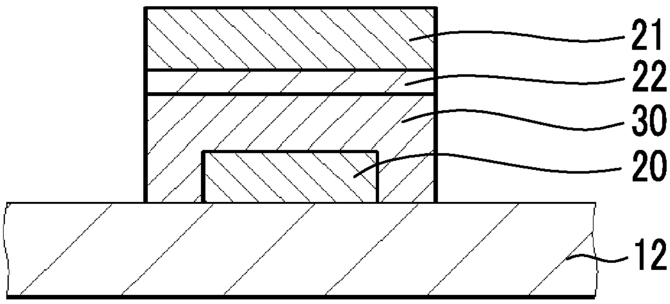


FIG. 10

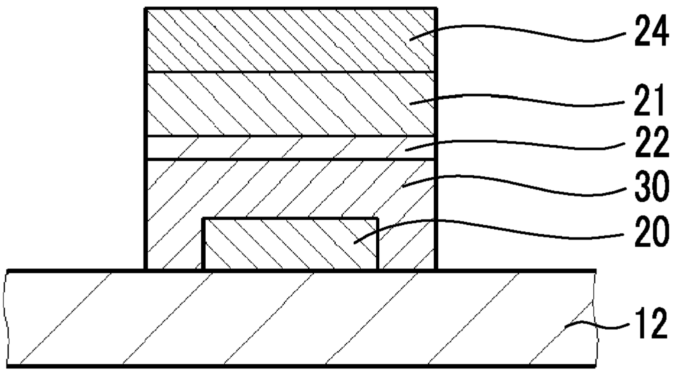

## REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

### Patent documents cited in the description


- JP 2015177099 A
- WO 2013143280 A1
- JP 2015170760 A
- JP 2015195361 A
- JP 2018006745 A


### Non-patent literature cited in the description


- Flexible pentacene ion sensitive field effect transistor with a hydrogenated silicon nitride surface treated Parylene top gate insulator. **DIALLO K et al.** APPLIED PHYSICS LETTERS. A I P PUBLISHING LLC, 2008, vol. 93, 183305
- **LI FLORA M.** *Organic Thin Film Transistor Integration,* 23 May 2008